Europäisches Patentamt

European Patent Office

Office européen des brevets

(19)

(11) **EP 0 709 970 A2**

(12) **EUROPEAN PATENT APPLICATION**

(43) Date of publication:
**01.05.1996 Bulletin 1996/18**

(51) Int Cl.⁶: **H03M 3/02**

(21) Application number: **95307498.6**

(22) Date of filing: **20.10.1995**

(84) Designated Contracting States:
**BE CH DE DK ES FR GB IE IT LI NL SE**

(30) Priority: **24.10.1994 GB 9421492**

(71) Applicant: **THE GENERAL ELECTRIC COMPANY, p.l.c.**
**London W1A 1EH (GB)**

(72) Inventors:
• **Joyce, Timothy R.**
**Stone, Staffordshire WIA 1EH (GB)**

• **Thurston, Andrew M.**
**Springfield, Essex, CM1 5QS (GB)**

(74) Representative: **Hoste, Colin Francis et al**
**The General Electric Company p.l.c.**
**GEC Patent Department**
**Waterhouse Lane**
**Chelmsford, Essex CM1 2QX (GB)**

(54) **DC correction arrangement for an analogue to digital converter**

(57)     An analogue to digital converter circuit arrangement comprising: an input (24) to receive an analogue signal, a first sampling means (9) operating at a first sampling frequency and operative to generate at an output (23) a digital signal; and a DC correction feedback path (10a) connected between the output (23) and the input (24). The DC correction feedback path comprising in order between the output (23) and input (24) means (25) for integrating said signal at the output (23), second sampling means (27) for sampling the integrated signal at a second sampling frequency which is a much lower frequency than said first sampling frequency, a digital to analogue converter (29) and means (31) for subtracting from the analogue signal received at the input (24) the analogue signal at the output of the digital to analogue converter.

Fig.3.

## Description

This invention relates to a DC correction arrangement for an analogue to digital converter, and is especially, though not exclusively, concerned with the use of such an arrangement in an integrated AC electrical power measuring circuit.

Such a power measuring circuit is disclosed in GB-B-2,239,097 and essentially comprises two inputs to receive analogue signals representative of instantaneous voltage and current. The voltage signal is passed through an analogue to digital converter (ADC) and multiplied by a digital signal representative of the current before being stored in an accumulator and sent to a display. As described, the current signal is digitised using a sigma-delta modulator. A sigma-delta modulator is an over sampled noise shaping quantizer and in the circuit described is configured to operate as an analogue to digital converter which produces an output which during each clock pulse period has a first or second value, i.e. "+1" or "-1", dependent upon the magnitude of the signal applied to the input (in this case on the instantaneous value of current) and upon the integrated sum of previous input and output values. When the input value is zero, the modulator output has values of "-1" and "+1" in equal ratios. When the input value progressively increases from zero in one sense, the modulator output has a value of "+1" progressively more often than a value "-1". Similarly, as the instantaneous value progressively increases from zero in the other sense, the modulator output has value "-1" progressively more often than "+1". The output is thus a bit stream of "+1"s' and "-1"s' and this lends itself particularly to incorporation within an integrated AC power measuring circuit, where two streams of voltage and current representative data can simply be multiplied together to give an instantaneous measurement of power. This can be accumulated to measure the consumed energy.

It is of particular importance in a power meter application that there is no DC offset in at least one arm of the circuit which could be multiplied up to give errors in the measured power. The above mentioned prior art document does disclose a means for removing DC terms, but the arrangement is not reliable and can still allow DC offsets to affect the short-term accuracy of the power measurement.

This invention provides an analogue to digital converter circuit arrangement comprising: an input to receive an analogue signal, a first sampling means operating at a first sampling frequency and operative to generate at an output a digital signal; and a DC correction feedback path connected between the output and the input and comprising in order between the output and input means for integrating said signal at the output, a second sampling means for sampling the integrated signal at a second sampling frequency which is a much lower frequency than said first sampling frequency, a digital to analogue converter and means for subtracting from the analogue signal received at the input the analogue signal at the output of the digital to analogue converter.

Since the second sampling frequency is much lower than the first sampling frequency and since the digital to analogue converter (DAC) in the DC correction feedback path exhibits a (sinX)/X frequency characteristic with nulls at frequency intervals equal to the second sampling frequency, the DC correction feedback path does not modify the phase of the input signal at the second sampling frequency. Accordingly if the second sampling frequency is selected to be at the frequency of the input signal effective DC correction is possible without affecting the phase of the input signal. This is particularly advantageous in an AC power measuring circuit where the input signal represents the voltage or current.

Conveniently the first sampling means comprises a sigma-delta modulator. The sigma-delta modulator can be regarded as a linear amplifier with poor noise performance at high frequencies and, as such, has little effect on the low frequency response. By operating the sigma-delta modulator at a much higher frequency than the second sampling means ensures stable operation of the arrangement. If the sampling frequencies were close to each other the DC correction feedback path could result in potential instability problems when using a sigma-delta modulator for the first sampling means.

When used in the power measuring architecture described previously, two ways of measuring the current have been proposed. The first comprises measuring the voltage drop across a shunt resistor. In such a case, the first sampling means conveniently comprises a sigma-delta modulator and the DC correction feedback path further includes means connected between the input and said sigma-delta modulator for modifying the loop gain. In such an arrangement the DC correction feedback path together with the sigma-delta modulator comprise a first order delta modulator.

In an alternative embodiment when the circuit is to be used with an inductive loop sensor for detecting a derivative of the current, a further integrator is connected in series with the sigma-delta modulator thereby making the sigma-delta modulator a second order system. In such a case the DC correction feedback path includes two DACs and the output from the second sampling means is simultaneously fed to the two DACs, the output from one of which is subtracted from the input to the modulator before the further integrator and the other of which is subtracted from the input after the further integrator.

Embodiments of the invention will now be described with reference to the accompanying drawings in which:

Figure 1 is a circuit diagram of a power measuring device;

Figure 2 shows an example of the output derived from a sigma-delta modulator as the input signal is varied sinusoidally;

Figure 3 is a circuit diagram of an arrangement suitable for connection to a shunt resistor current measuring device for incorporation into the circuit of Figure 1;

Figure 4 is a circuit diagram of an arrangement suitable for connection to an inductive loop current measuring device for incorporation into the circuit of Figure 1; and

Figure 5 is a diagram showing the open loop response of the DC feedback loop by means of a DC pulse as it progresses around the circuit of Figure 4.

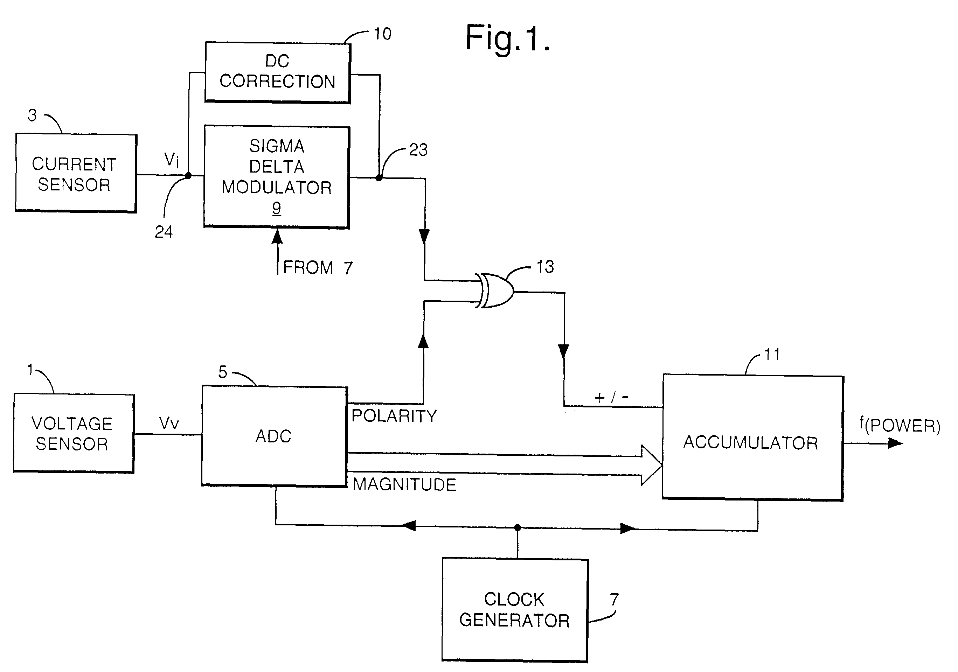

Referring firstly to Figure 1, a power measuring device includes a voltage sensor 1 and a current sensor 3 which respectively produce analogue outputs $V_v$ and $V_i$ which are respectively representative of the instantaneous values of the voltage and current supplied to a load (not shown) from an alternating current (AC) electricity supply (not shown).

The voltage representative output $V_v$ of the sensor 1 is applied to an analogue to digital converter (ADC) 5 within which it is sampled at regular intervals under the control of pulses derived from a clock generator 7 to produce a quantised representation of the magnitude of the output of the sensor 1, and hence of the instantaneous magnitude of the voltage supplied to the load, and a further bit representative of the polarity of the voltage. The clock frequency is high compared with the frequency of the AC electricity supply, eg 67kHz for a 50Hz supply.

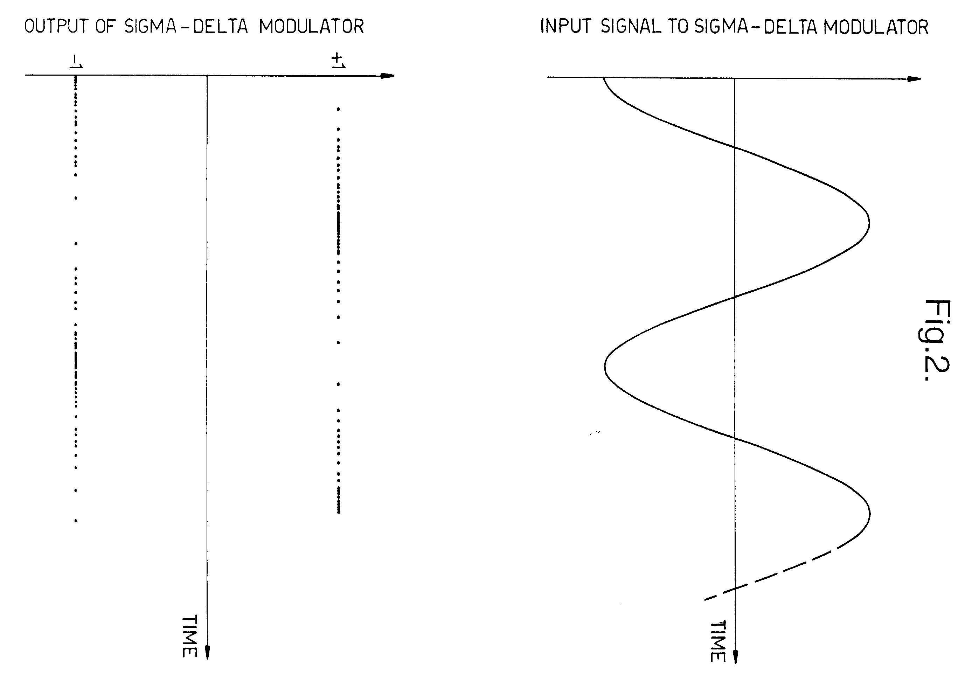

The current representative output $V_i$ of the sensor 3 is applied to a sigma-delta modulator 9 which includes a DC correction arrangement 10, the subject of this patent application. The modulator 9, under control of pulses from the clock generator 7, produces an output which during each clock pulse period has a first or second value, i.e. +1 or -1, dependent in part on the magnitude of the output $V_i$ of the sensor 3, and hence on the input value of the current supplied to the load. As shown in Figure 2 when the input value is zero the modulator output has values of -1 and +1 for equal numbers of clock periods, when the input value progressively increases from zero in one sense the modulator output has a value +1 progressively more often than a value -1. Similarly as the instantaneous value progressively increases from zero in the other sense the modulator output has a value -1 progressively more often than a value +1.

Referring to Figure 1, the voltage magnitude representative output of the ADC 5 is supplied to an accumulator 11 and the voltage polarity representative output bit is supplied to one input of an exclusive-or gate 13. The output of the modulator 9 is supplied to the other input of the gate 13.

The accumulator 11 is arranged to add the voltage magnitude representative output of the converter 5, or to subtract it from, the count in the accumulator 11 in dependence on the output of the gate 13, once during each clock period. As a result, the count in the accumulator 11 changes in any given interval by the output of the converter 5 times the number of times more in that interval that the output of the modulator 9 had one value rather than the other. The count in the accumulator 11 thus changes in proportion to the sum of the products in the instantaneous voltage and current supplied to the load at the instance of sampling the voltage, i.e. in proportion to the power supplied to the load.

The accumulator 11 produces an output pulse each time the count of the accumulator 11 exceeds a predetermined value, the count of the accumulator 11 is then reset. The reset operation comprises reducing the count of the accumulator by a predetermined amount, not to zero to form a cyclic register. The output of the accumulator 11 thus comprises a train of pulses f(power) whose pulse rate is representative of the power supplied to the load. This pulse train is typically supplied to a counter (not shown) to provide a measure of the energy supplied to the load.

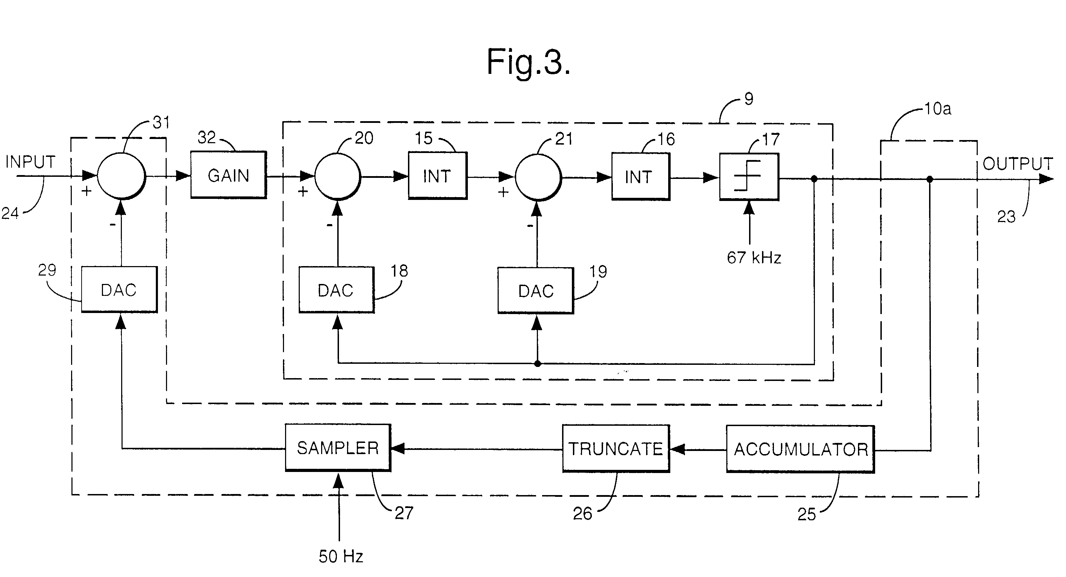

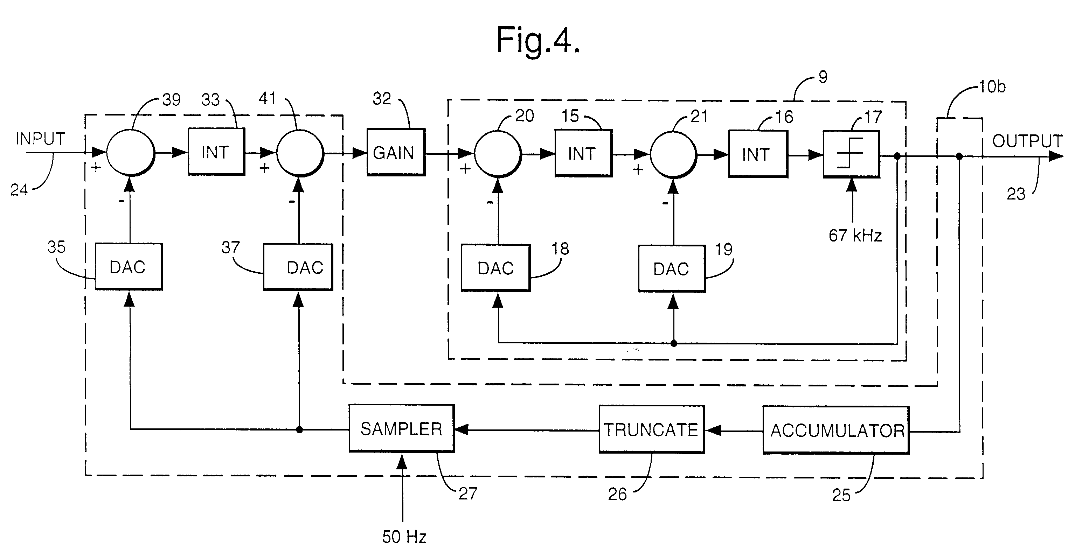

The sigma-delta modulator 9 and associated DC correction arrangements are shown in Figures 3 and an alternative arrangement in Figure 4. Each sigma-delta modulator 9 is of a known second order type comprising two integrators (Int) 15, 16 connected in series, the output from which is passed through a quantiser 17 which is clocked at a rate of 67kHz. The output from the quantiser is fed back via two digital to analogue converters DAC's 18, 19 which operate simultaneously. The output from the DAC 18 is subtracted from the input signal before it passes through either integrator 15, 16, while the output from the second DAC 19 is subtracted from the input signal at a node 21 situated between the two integrators 15, 16. The output at line 23 is a stream of "+1s'" and "-1s'" whose relative proportions vary according to the magnitude of the input signal as described previously.

In order to prevent the accumulation of any DC errors in the output, a DC correction arrangement 10 is provided between the output 23 and input 24. The DC correction arrangement 10a shown in Figure 3, is intended for use with a current sensor 3 of the type comprising a shunt resistor and in essence together with the sigma-delta modulator 9 comprises a first order delta modulator. The digital output at 23 is firstly accumulated in a ten bit accumulator 25 which, in effect, performs an integrating function. The output from the accumulator 25 is then supplied to a truncation stage 26 which has the effect of removing a proportion of the least significant bits from, and scaling the output. It is preferred that excessive truncation is avoided for reasons that will be explained later on. Truncation by four bits is preferred.

The feedback arrangement 10a is designed according to delta modulation principles. The digital gain of the feedforward stage, representing the transfer function between the digital input to the DC correction feedback DAC 29 and the single bit digital output of the modulator 9, $K_1$ is given by:

$$K_1 = (I_{DAC29} \times Gain_{32})/I_{DAC18}$$

where $I_{DAC29}$ and $I_{DAC18}$ represent the current within the DACs'29 and 18 respectively, and $Gain_{32}$ represents the amount of gain introduced by the stage 32.

The output of the sigma-delta modulator 9 is accumulated, representing an integration, and the response of the gain stage 32, the sigma-delta converter 9 and the accumulator 25 to one pulse from the feedback DAC 29 thus ramps linearly for the duration of the DAC pulse, and then retains its value after the removal of this pulse. Resampling the output of the accumulator 25 at 50Hz then allows the equivalent digital filtering function of the feedback loop to be written as:

$$\text{Loop filter response} = (I_{DAC29} \times Gain_{32})/I_{DAC18} \times 67000/50 \times 1/(z\text{-}1),$$

where $1/(z\text{-}1)$ represents, in z transform notation, the integration performed by the accumulator 25 resampled at 50 Hz.

It is convenient to make the scaling factors (i.e. the first two terms in the above loop filter response) equal to a binary number so that simple truncation at truncation stage 26 may be used to restore the overall transfer function to its unscaled form. A choice of which binary scaling factor to select requires two parameters to be considered; the range of the DC correction DAC 29 and the noise generated by the correction process. If a low value is selected then the DAC 29 has a very small effect at the input 24 to the converter, and many quantising levels will be required to cover an adequate range. For example, if a unity scaling factor is employed, thus requiring no truncation, each DAC level will provide DC cancellation for only .07% of the full scale input of the converter. As more truncation is employed, each DAC level may be extended to cover more DC correction range at the input to the converter, however the noise generated by the feedback correction mechanism becomes more dominant and would ultimately start to limit the available performance. It has been found that scaling by a factor of sixteen at the truncation stage 26 gives acceptable results. Thus the truncation stage 26 is selected to remove the four least significant bits of the output from the accumulator 25. The effective correction range of each bit of the DAC 29 corresponds to 1.2% of the peak amplitude of the modulator 9. A six bit DAC 29 thus corrects for $\pm 38\%$ of the peak amplitude, thus requiring the presence of a ten bit accumulator 25.

The arrangement shown in Figure 4 is for use with a current sensor 3 of the inductive loop type which measures a derivative of the current. Accordingly an extra integrator 33 is required on the input side of the circuit. The modulator 9 and the DC correction path 10b are generally similar to that described with reference to Figure 3 and the same parts are identified with the same reference numerals. Instead of the single DAC 29, the output from the sampler 27 is fed in parallel to a pair of DACs 35, 37. The output from one of the DACs 35 is subtracted from the input at a node 39 before the input signal has been integrated by the integrator 33. The output of the other DAC 37 is subtracted from the input signal at a node 41 disposed after the integrator 33. The DC correction arrangement is thus a second order arrangement with the inner feedback via DAC 37 being required to stabilise the second order loop. The truncation stage 26 is again arranged to remove the four least significant bits from the output of a ten bit accumulator 25.

The gain through the analogue path between the digital input of DAC 37 and the single bit output on line 23 of the sigma-delta modulator 9, $K_2$, is given by:

$$K_2 = I_{DAC37}/I_{DAC18},$$

where $I_{DAC37}$ is the differential current per bit from the multibit DAC 37 and $I_{DAC18}$ is the output current amplitude of the DAC 18 within the modulator 9. An exact value for $I_{DAC37}$ can only be determined by considering the open loop response of the correction arrangement 10b shown in Figure 4, and this is given by:

$$\text{impulse response} = 0, 2, 3, 4, 5, \text{etc.}$$

where the negative sign at the summing nodes is not represented.

Additionally, this impulse response must be scaled up by a factor of sixteen to accommodate the truncation by four bits. In addition, the signal passing through DAC 37 is selected to have an amplitude of twice that passing through DAC 35 and an analogue representation of the transfer function is given by:

$$1.5 + 50/s.$$

Equations for the output levels of the two DACs are also given below:

$$I_{DAC37} = (1.5 \times 16 \times 50 \times I_{DAC18})/67000.$$

The equation for $I_{DAC35}$ assumes that the integrator 33 has an output current to input current transfer function of $1/s$, and should be rescaled otherwise.

$$I_{DAC35} = (50 \times I_{DAC37})/1.5$$

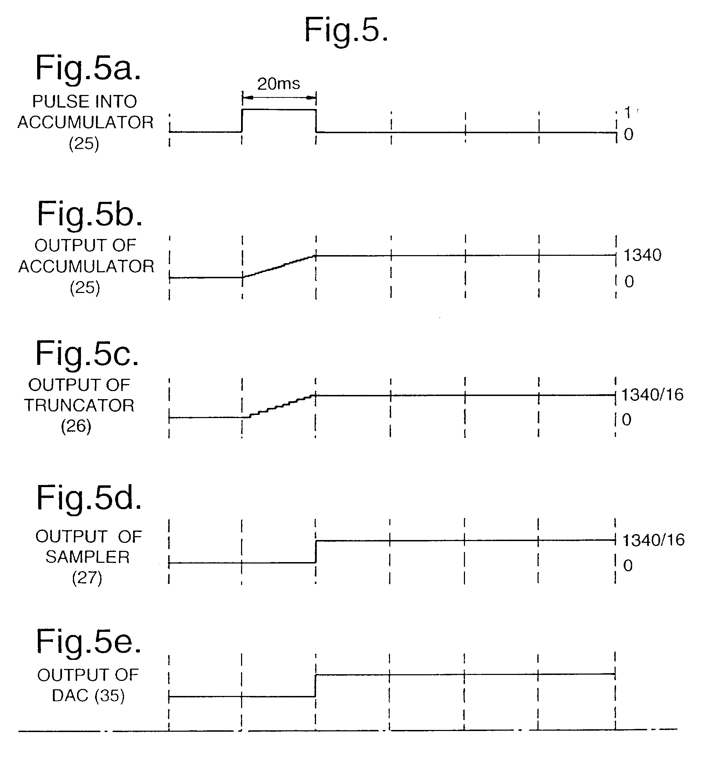

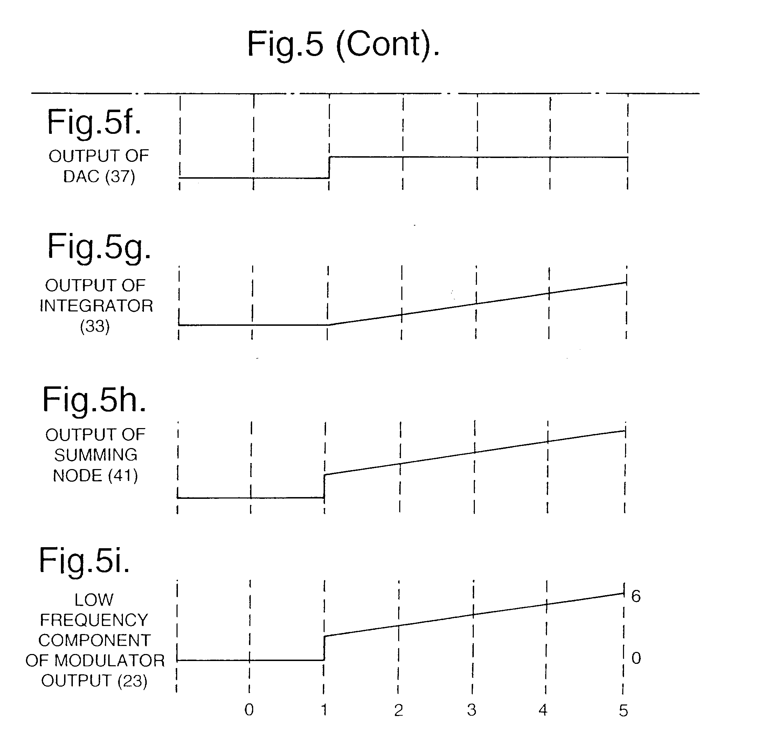

Figure 5 illustrates the open loop pulse response of the feedback for the arrangement shown in Figure 4. Figure 5a shows a 20ms rectangular pulse entering the accumulator 25. Figure 5b shows the output of the accumulator 25, assuming the sampling rate of 67kHz. Figure 5c shows the output signal after having been truncated at stage 26. Figure 5d shows the consequential output of the resampler 27 and Figures 5e and 5f respectively the outputs from the DAC 35 and DAC 37. Figure 5g shows the response of the integrator 33 to the output from DAC 35 while Figure 5h shows the combined effect of the response shown in Figure 5g and the output of DAC 37, as shown in Figure 5f. Figure 5i shows the low frequency component of the output of the modulator (23), which is of the correct form to implement a second order sigma-delta response.

For both architectures the use of resampling at 50Hz combined with the above design parameters means that the circuit can switch between any set of DC levels in one clock period at the 50Hz rate. In practice, settling may take two clock cycles, since any change in the DC offset may not occur coincidentally with a resampling clock edge, and complete settling of the DC feedback path occurs within 40ms. Furthermore because a relatively low level of truncation is employed the amount of electrical charge that need be collected before the DAC 29, or DACs 35, 37 switch between levels is not significant, eg about .085 coulombs. This ensures that dead zones, i.e. times during which a DC offset can occur due to the DAC being between levels, need not be of significant length. Both the described architectures can be easily implemented in integrated form along with the architecture show in Figure 1.

It will be appreciated that variations may be made without departing from the scope of the present invention. For example, whilst in the embodiments a sigma-delta modulator 9 is described, the DC correction arrangement 10 can be applied to other forms of sampling means eg a multibit analogue to digital converter.

## Claims

1. An analogue to digital converter circuit arrangement comprising: an input (24) to receive an analogue signal, a first sampling means (9) operating at a first sampling frequency and operative to generate at an output (23) a digital signal; and a DC correction feedback path (10) connected between the output (23) and the input (24) comprising in order between the output (23) and input (24) means (25) for integrating said signal at the output (23), a second sampling means (27) for sampling the integrated signal at a second sampling frequency which is a much lower frequency than said first sampling frequency, a digital to analogue converter (29) and means (31) for subtracting from the analogue signal received at the input (24) the analogue signal at the output of the digital to analogue converter.

2. An analogue to digital converter according to claim 1 in which the first sampling means (9) is a sigma-delta modulator which produces a digital signal which, during periods of equal duration, has a first or a second value such that the net difference between the number of periods of the first value to the number of the periods of the second value varies with the value of the analogue signal.

3. An analogue to digital converter according to claim 1 or 2 in which the DC correction feedback path (10) includes means (26) for truncating the output signal from the integrating means (25).

4. An analogue to digital converter according to claim 2 or 3 in which the DC correction path comprises a first order delta modulator and the arrangement further includes means (32) connected between the input (24) and said sigma-delta modulator (9) for modifying the loop gain.

5. An analogue to digital convertor according to claim 2 or 3 in which a further integrator (33) is connected in series between the input (24) and said sigma-delta modulator (9) and in which the DC correction path (10) includes two DACs (35, 37) connected in parallel to the output from the second sampling means (27), the output from one DAC (35) of which is subtracted from the input (24) to the sigma-delta modulator before the further integrator (33), and the output from the other DAC (37) is subtracted from the input (24) after the further integrator (33).

6. An analogue to digital converter according to any preceding claim in which the second sampling frequency is substantially equal to the frequency of the input signal.

7. An analogue to digital converter according to any preceding claim in which the first sampling frequency is about 67kHz, and the second sampling frequency is about 50Hz.

8. An analogue to digital converter according to any preceding claim in which the integrating means (25) comprises a ten bit accumulator.

9. An analogue to digital converter according to any of claims 3 to 8 in which the means (26) for truncating is arranged to remove the four least significant bits of the output from the integrating means 25.

10. An analogue to digital converter according to any preceding claim in which the or each DAC (35, 37) within the DC correction feedback path is a six bit device.

11. An analogue to digital converter as claimed in any preceding claim, connected to an AC power measuring device to convert one or both input signals representative of instantaneous current and voltage into digital form.

# Fig.1.

# Fig.2.

# Fig.3.

Fig.4.

EP 0 709 970 A2

# Fig.5.

## Fig.5a.
PULSE INTO
ACCUMULATOR
(25)

20ms

1

0

## Fig.5b.
OUTPUT OF
ACCUMULATOR
(25)

1340

0

## Fig.5c.
OUTPUT OF
TRUNCATOR
(26)

1340/16

0

## Fig.5d.
OUTPUT OF
SAMPLER
(27)

1340/16

0

## Fig.5e.
OUTPUT OF
DAC (35)

# Fig.5 (Cont).

### Fig.5f.
OUTPUT OF
DAC (37)

### Fig.5g.
OUTPUT OF
INTEGRATOR
(33)

### Fig.5h.
OUTPUT OF
SUMMING
NODE (41)

### Fig.5i.
LOW
FREQUENCY
COMPONENT
OF MODULATOR
OUTPUT (23)

6

0

0   1   2   3   4   5